# EUROPÄISCHE PATENTANMELDUNG

(11) **EP 4 669 044 A1**
(43) Veröffentlichungstag der Anmeldung: **24.12.2025**
(21) Anmeldenummer: 24182662.7
(22) Anmeldetag: 17.06.2024
(51) Int. Cl.: H05K 7/20

(54) **KLEBEGEOMETRIE**

(71) Anmelder: VDL ETG Switzerland AG, 9477 Trübbach (CH)
(72) Erfinder: Jüsten, Detlef, 8880 Walenstadt (CH)
(74) Vertreter: Keller Schneider Patent- und Markenanwälte AG

(57) **Zusammenfassung**

Eine Anordnung zur Bildung eines I<ühlkörpers (2) umfasst einen Grundkörper (200) und einen Deckkörper (200), wobei im Grundkörper (200) ein I<ühlkanal (204, 205) in einer Grundkörperebene angeordnet ist, wobei der I<ühlkanal (204, 205) zumindest einen offenen I<ühlkanalabschnitt umfasst, wobei mit dem Deckkörper (210) der Grundkörper (200) zur Bildung des I<ühlkörpers (2) derart abgedeckt werden kann, dass der offene I<ühlkanalabschnitt mit dem Deckkörper (200) abdeckbar ist. Der Grundkörper (200) weist weiter eine Klebenut (204, 205) zur Aufnahme eines Klebstoffes (300) auf und der Deckkörper (200) weist ein Profil (211, 212) auf, wobei das Profil (211, 212) bei mit dem Deckkörper (200) abgedecktem Grundkörper (200) in die Klebenut (204, 205) hinein ragt.

## Beschreibung

### Technisches Gebiet

Die Erfindung betrifft eine Anordnung zur Bildung eines I<ühlkörpers, umfassend einen Grundkörper und einen Deckkörper, wobei im Grundkörper ein I<ühlkanal in einer Grundkörperebene angeordnet ist, wobei der I<ühlkanal zumindest einen offenen I<ühlkanalabschnitt umfasst, wobei mit dem Deckköper der Grundkörper zur Bildung des I<ühlkörpers derart abgedeckt werden kann, dass der offene I<ühlkanalabschnitt mit dem Deckkörper abdeckbar ist, und wobei die I<ühlplatte weiter eine Klebenut zur Aufnahme eines Klebstoffes aufweist und der Deckkörper ein Profil aufweist, welches bei mit dem Deckkörper abgedecktem Grundkörper in die Klebenut hinein ragt. Die Erfindung betrifft weiter einen I<ühlkörper und ein Verfahren zur Herstellung eines I<ühlkörpers.

### Stand der Technik

In der Industrie spielen effiziente I<ühltechnologien eine entscheidende Rolle, um die Leistungsfähigkeit, Zuverlässigkeit und Langlebigkeit von Komponenten zu gewährleisten.

I<ühlelemente respektive I<ühlkörper, insbesondere solche aus Aluminium, sind integraler Bestandteil von Fahrzeugkühlsystemen, die dazu dienen, die Betriebstemperaturen von Motoren, Batterien, Elektronik und anderen Komponenten auf einem optimalen Niveau zu halten. Eine effektive Wärmeableitung ist von entscheidender Bedeutung, um eine Überhitzung zu vermeiden und die Betriebsbedingungen zu optimieren, was wiederum die Leistung, den I<raftstoffverbrauch und die Emissionswerte beeinflusst. Angesichts der steigenden Anforderungen an Effizienz, Leistung und Umweltfreundlichkeit ist die kontinuierliche Innovation und Optimierung von I<ühltechnologien von grösster Bedeutung für die Fahrzeugentwicklung und -produktion.

Aber auch in anderen Industriesektoren, bei welchen Wärme, zum Beispiel Abwärme abtransportiert werden soll, werden I<ühlelemente eingesetzt (nicht abschliessende Aufzählung):
1. I<ühlelemente werden in elektronischen Geräten wie Computern, Smartphones, Fernsehern, Servern, und anderen Geräten eingesetzt, um die Betriebstemperaturen von Prozessoren, Grafikkarten, Leistungstransistoren und anderen Komponenten zu regulieren und Überhitzung zu verhindern.
2. In medizinischen Geräten wie MRI-Scannern, CT-Scannern, Ultraschallgeräten und medizinischen Lasergeräten werden I<ühlelemente verwendet, um die Betriebstemperaturen von elektronischen Komponenten zu kontrollieren und eine zuverlässige Leistung sicherzustellen.
3. In verschiedenen industriellen Anwendungen wie Halbleiterproduktion, Laserbearbeitungsmaschinen, Schweissanlagen, CNC-Maschinen und anderen Produktionsanlagen werden I<ühlelemente eingesetzt, um die Betriebstemperaturen von Hochleistungskomponenten zu regulieren und eine hohe Produktionsqualität sicherzustellen.
4. Luft- und Raumfahrt: In Luft- und Raumfahrtanwendungen werden I<ühlelemente verwendet, um elektronische Systeme, Triebwerke und andere Komponenten zu kühlen und eine zuverlässige Leistung unter extremen Bedingungen zu gewährleisten.

Es sind viele unterschiedliche Typen von I<ühlelementen bekannt. I<ühlelemente können zur Durchleitung eines I<ühlmediums vorgesehen sein. Solche I<ühlelemente können zum Beispiel einen Grundkörper mit eingelassenen I<ühlkanälen umfassen, welche typischerweise durch einen Deckel abgedeckt werden. Die I<ühlkanäle sind typischerweise mäanderförmig oder ähnlich angeordnet. Solche I<ühlelemente können mit einem I<ühlmedium, insbesondere einer I<ühlflüssigkeit oder einem Gas betrieben werden. Mittels Wahl des I<ühlmediums und der Durchflussrate kann die I<ühlleistung damit gesteuert werden.

Solche I<ühlelemente werden typischerweise aus einem Material hergestellt, welches eine gute Wärmeleitfähigkeit aufweist. Bei der Materialwahl wird unter anderem das Einsatzgebiet, die Material- und Herstellungskosten berücksichtigt. Weiter sollte das Material gegenüber dem I<ühlfluid möglichst inert sein. Typische Materialien sind zum Beispiel Aluminium und Kupfer, wobei Aluminium kostengünstig und Kupfer aufgrund der besseren Wärmeleitfähigkeit eine bessere I<ühlleistung aufweisen kann.

Bei der Herstellung von I<ühlelementen mit einem Grundkörper und einem Deckel besteht die Herausforderung, in effizienter und präziser Weise eine dichte Verbindung zwischen dem Grundkörper und dem Deckel zu erreichen. Die Präzision ist erforderlich, damit das I<ühlelement in der Anwendung möglichst perfekt passt und damit vom zu kühlenden Gegenstand hin zum I<ühlelement eine gute Wärmeübertragung gewährleistet ist. Damit kann zum Beispiel eine Planarität des I<ühlelements wichtig sein, um eine grosse I<ontaktfläche mit dem zu kühlenden Gegenstand zu gewährleisten.

Es ist bekannt den Deckel durch Schweissen mit dem, die I<ühlkanäle aufweisenden Grundkörper zu verbinden. Beim Schweissen besteht jedoch die Gefahr, dass es aufgrund von Temperaturänderung zu Spannungen und Verzug kommt. Typischerweise wird daher mit einem Übermass gearbeitet und die vorstehenden Bereiche werden nachträglich abtragen. Es ist zwar in einigen Fällen möglich, von der Rückseite der Platte Schweisslinien entlang der gegenüberliegenden Schweisslinien auf der Vorderseite zu fahren ("Gegenschweissen"), so dass ein Teil der Spannungen und des Verzugs quasi aufgehoben bzw. neutralisiert wird. Bei nicht ebenen Platten ist das aber nicht immer möglich. Auch ist das Schweissverfahren relativ teuer, insbesondere aufgrund notwendiger Nachbearbeitungsschritten respektive Vorbereitungsschritten (Gegenschweissen).

Trotz der Fortschritte im Bereich des Schweissens bestehen weiterhin Herausforderungen und Optimierungspotenziale bei der Konstruktion von I<ühlelementen aus einem Grundkörper und einem Deckel um eine präzise und dichte Verklebung des Deckels mit dem Grundkörper zu erreichen.

### Darstellung der Erfindung

Aufgabe der Erfindung ist es, eine dem eingangs genannten technischen Gebiet zugehörende Anordnung zur Bildung eines I<ühlkörpers zu schaffen, bei welchem der Deckel in präziser Weise auf dem Grundkörper befestigt werden kann, wobei ein Ausmass des Verzugs und damit ein Aufwand der Nachbearbeitung des I<ühlkörpers reduziert ist.

Die Lösung der Aufgabe ist durch die Merkmale des Anspruchs 1 definiert. Gemäss der Erfindung weist der Grundkörper weiter eine Klebenut zur Aufnahme eines Klebstoffes auf und der Deckkörper weist ein Profil auf, wobei das Profil bei mit dem Deckkörper abgedecktem Grundkörper in die Klebenut hinein ragt. Durch den Klebevorgang fallen gegenüber dem üblicherweise eingesetzten Schweissverfahren die grossen Temperaturschwankungen weg, womit ein Verzug reduziert werden kann. Damit kann auch eine Nachbearbeitung reduziert oder sogar weg gelassen werden. Der I<ühlkörper kann damit kostengünstig und dennoch präzise produziert werden. Erfindungsgemäss ist eine Klebenut vorgesehen, um zu verhindern, dass Klebstoff in den I<ühlkanal gelangt. Die Klebstoffmenge sowie die Spaltmasse zwischen dem Profil und der Klebenut können dazu derart dimensioniert sein, dass grundsätzlich ein Eindringen von Klebstoff in den I<ühlkanal verhindert wird.

Das erfindungsgemässe Verfahren ermöglicht es, Anordnungen zur Bildung von grossflächigen I<ühlkörpern mit hoher Planarität bereitzustellen.

Beispielsweise kann der Grundkörper und/oder der daraus hergestellt I<ühlkörper eine Länge von 100 - 2'000 mm, eine Breite von 100 - 1'500 mm und/oder einer Dicke von 5 - 100 mm aufweisen. Insbesondere kann der Grundkörper und/oder der daraus hergestellt I<ühlkörper eine Länge von 800 - 1'700 mm, eine Breite von 500 - 1'200 mm und/oder einer Dicke von 7 - 70 mm aufweisen. Im Speziellen weist der Grundkörper und/oder der daraus hergestellt I<ühlkörper eine Länge von 1'000 - 1'400 mm, eine Breite von 600 - 800 mm und/oder einer Dicke von 8 - 40 mm auf.

Vorzugsweise ist zwischen der Klebenut und dem I<ühlkanal eine Rippe ausgebildet, welche die Klebenut von dem I<ühlkanal trennt. Dadurch, dass eine Rippe vorgesehen ist, welche die Klebenut vom I<ühlkanal trennt, wird einerseits eine Auflage für den Deckel geschaffen, womit eine präzise Positionierung des Deckels auf dem Grundkörper ermöglicht wird. Weiter wird damit eine besonders optimale Trennung zwischen der Klebenut und dem I<ühlkanal erreicht, womit bei der Montage des I<ühlkörpers ein Eindringen von Klebstoff von der Klebenut in den I<ühlkanal weitgehend vermieden werden kann.

Dieser Effekt kann mutmasslich durch eine geeignete Formgebung des Profils optimiert werden. Es wird vermutet, dass beim Eintauchen des Profils in die, den Klebstoff enthaltende Klebenut nach dem Wirkprinzip von Tragflächen ein Unterdruck derart erzeugt werden kann, dass ein Eindringen von Klebstoff in den I<ühlkanal verhinderbar ist (siehe weiter unten).

Weiter wird durch die Anordnung der Rippe zwischen der Klebenut und dem I<ühlkanal eine besonders kompakte Ausbildung des Kühlkörpers erreicht, insbesondere in einer Richtung Rechtwinklig zur Grundkörperebene. Damit werden wiederum die Abstände zwischen dem I<ühlkanal und dem zu kühlenden Gegenstand gering gehalten, womit eine besonders hohe I<ühlleistung erreicht werden kann.

Die Grundkörperebene ist vorliegend parallel zu einer Ebene ausgerichtet, in welcher der I<ühlkanal verläuft.

Besonders bevorzugt ist die Klebenut beidseitig des I<ühlkanals angeordnet. Damit wird eine besonders dichter Abschluss des I<ühlkanals erreicht. Unter Umständen kann auch bloss einseitig des I<ühlkanals eine Klebenut vorgesehen sein. Dies kann zum Beispiel dann sinnvoll sein, wenn zwei I<ühlkanäle in geringem Abstand parallel verlaufen (z.B. bei einem U-förmigen Verlauf des I<ühlkanals), wobei auf eine zwischen den I<ühlkanälen liegende Klebenut verzichtet werden kann.

In einem Verfahren zur Herstellung eines Kühlkörpers mit einer obig beschriebenen Anordnung wird ein Klebstoff in die Klebenut eingetragen und anschliessend der Deckköper derart auf dem Grundkörper angeordnet, dass das Profil in die Nut hinein ragt und der Klebstoff das Profil in der Nut festklebt. Im I<ühlkörper ist schliesslich der Deckkörper derart auf dem Grundkörper angeordnet, dass das Profil in die Nut hinein ragt, wobei das Profil mit einem Klebstoff in der Nut verklebt ist.

Die Anordnung zur Bildung eines I<ühlkörpers umfasst einen Grundkörper mit einem I<ühlkanal und einen Deckkörper, wobei im Grundkörper ein I<ühlkanal in einer Grundkörperebene angeordnet ist. Der Grundkörper ist vorzugsweise als plattenförmiges Element ausgebildet, kann aber auch anderweitige Formen aufweisen. Der Grundkörper ist vorzugsweise aus einem Material ausgebildet, welches eine gute Wärmeleitfähigkeit aufweist, insbesondere mehr als 100 W/(m*I<). Das Material umfasst zum Beispiel Aluminium, Kupfer oder Metalllegierungen mit entsprechend guter Wärmeleitfähigkeit. Besonders bevorzugt wird für den Grundkörper Aluminium eingesetzt, da dies kostengünstig und einfach zu verarbeitet ist. Sofern jedoch die I<ühlleistung besonders hoch sein soll, kann auch Kupfer eingesetzt werden. Typischerweise wird der Deckkörper aus demselben Material wie der Grundkörper hergestellt - dies ist jedoch nicht zwingend. Es ist auch denkbar, entweder den Grundkörper oder den Deckkörper mit einem Material herzustellen, welches eine Wärmeleitfähigkeit von weniger als 100 W/(m*K) aufweist, insbesondere wenn in der Anwendung die Wärme nur einseitig am I<ühlelement aufgenommen wird und lokal nicht abgegeben werden soll.

Der I<ühlkanal umfasst zumindest einen offenen I<ühlkanalabschnitt. Dieser kann zum Beispiel in den Grundkörper mit einem Spanabhebenden Verfahren eingelassen sein, insbesondere eingefräst sein. Alternativ kann der I<ühlkanal auch in einem Guss-Verfahren in den Grundkörper eingebracht sein. Schliesslich kann der Grundkörper auch mittels eines Additiven Verfahrens (3D-Druck) hergestellt sein. Dem Fachmann sind weitere Varianten bekannt.

Der offene I<ühlkanalabschnitt weist im I<ühlkörper mindestens einen Einlass und einen Auslass auf. Der Einlass und der Auslass können im Grundkörper, im Deckkörper oder im Grund- und Deckkörper ausgebildet sein. Der Ein- und Auslass kann zum Beispiel im I<ühlkörper rechtwinklig zu Grundkörperebene ausgebildet sein. Weiter kann der Ein- und Auslass auch Stirnseitig am Grundkörper ausgebildet sein. Der Ein- und Auslass können derart ausgebildet sein, dass mehrere I<ühlkörper parallel oder seriell zusammen geschaltet werden können. Dem Fachmann sind weitere Varianten bekannt.

Der I<ühlkanalabschnitt kann rechtwinklig zur Längsrichtung des I<ühlkanals eine rechteckige, halbrunde oder anderweitige Querschnittsform aufweisen.

Mit dem Deckköper kann der Grundkörper zur Bildung des I<ühlkörpers derart abgedeckt werden, dass der offene I<ühlkanalabschnitt mit dem Deckkörper abdeckbar ist. Typischerweise wird nach dem Abdecken des I<ühlkanalabschnitts mit dem Deckkörper lediglich der mindestens eine Einlass und Auslass offen, so dass ein I<ühlmittel vom Einlass zum Auslass durch den I<ühlkanal hindurch fliessen kann. Dem Fachmann ist klar, dass der I<ühlkörper auch mehr als ein Einlass respektive mehr als ein Auslass aufweisen kann.

Das Profil und die Klebenut sind vorzugsweise derart ausgebildet, dass bei einem Einfügen des Profils in die Klebenut auf einer dem I<ühlkanal gegenüberliegenden Seite des Profils ein Unterdruck erzeugbar ist, womit bei einem Klebevorgang ein Eindringen von Klebstoff in den I<ühlkanal verhinderbar ist. Dem Fachmann sind solche Profilgeometrien, insbesondere von Flügelgeometrien aus der Aviatik bekannt.

Vorzugsweise sind das Profil und die Klebenut derart ausgebildet, dass beim Einfügen des Profils in die, den Klebstoff enthaltende Klebenut der Klebstoff im Wesentlichen auf eine dem I<ühlkanal gegenüberliegenden Seite des Profils verdrängt wird.

In Varianten kann auf diese Ausbildung des Profils auch verzichtet werden. Es ist zum Beispiel denkbar, den I<ühlkanal mit einem Druck derart zu beaufschlagen, dass der Klebstoff nicht in den I<ühlkanal eindringen kann. Dies würde jedoch einen fertigungstechnischen Mehraufwand bedeuten.

Vorzugsweise weist das Profil bei mit dem Deckkörper abgedecktem Grundkörper einen Profilschnitt rechtwinklig zu einer Längsrichtung der Klebenut auf, wobei der Profilschnitt asymmetrisch ist und insbesondere eine Breite sich in einem Distalen Bereich des Profilschnitts hin zu einem distalen Ende des Profilschnitts kontinuierlich verjüngt. Durch die asymmetrische Ausbildung des Profilabschnitts kann die Klebenut symmetrisch, insbesondere zum Beispiel im Wesentlichen rechteckig ausgebildet sein. Die asymmetrische Ausbildung des Profils ermöglicht damit eine asymmetrische Druckverteilung auf den Klebstoff in der Klebenut, womit ein Eindringen von Klebstoff in den I<ühlkanal vermindert oder verhindert werden kann. Durch die Verjüngung des Querschnitts des Profils hin zum distalen Ende des Profils wird bei der Montage eine Teilung des 1<lebevolumens in der Klebenut erreicht, wobei durch die asymmetrische Ausbildung eine asymmetrische Teilung des 1<lebevolumens erreicht wird. Damit kann beim Einführen des Profils das 1<lebevolumen in einen grösseren 1<lebevolumenteil und einen kleineren 1<lebevolumenteil geteilt werden, wobei der kleinere 1<lebevolumenteil zwischen dem I<ühlkanal und dem grösseren 1<lebevolumenteil liegt. Damit wird der grössere 1<lebevolumenteil von dem I<ühlkanal weg geführt, womit wiederum das Risiko des Eindringens von Klebstoff in den I<ühlkanal verringert werden kann.

In Varianten kann das Profil auch symmetrisch ausgebildet sein. In diesem Fall kann die Klebenut einen entsprechenden asymmetrischen Querschnitt aufweisen, welcher verhindert, dass Klebstoff in den I<ühlkanal gelangt.

Bevorzugt verläuft der Profilschnitt auf einer dem I<ühlkanal zugewandten Seite, in einem distalen Bereich rechtwinklig zur Längsrichtung der Klebenut gerade. Besonders bevorzugt ist die dem I<ühlkanal zugewandte Seite rechtwinklig oder im Wesentlichen rechtwinklig zur Grundkörperebene ausgerichtet. Ebenso ist bevorzugt eine der Klebenut zugewandte Wand des I<ühlkanals rechtwinklig oder im Wesentlichen rechtwinklig zur Grundkörperebene ausgerichtet. Die Rippe weist vorzugsweise eine der Klebenut zugewandte Seite auf, welche rechtwinklig oder im Wesentlichen rechtwinklig zur Grundkörperebene ausgerichtete ist. Das Profil und die Klebenut sind damit vorzugsweise derart ausgebildet, dass sich in montiertem Zustand des I<ühlkörpers zwischen dem Profil und der der Klebenut zugewandte Seite der Rippe ein Spalt zur Aufnahme des Klebstoffes bildet, wobei der Spalt vorzugsweise eine im Querschnitt konstante Spaltbreite aufweist. Eine geringe Spaltbreite hat insbesondere bei höherviskosen Klebstoffen den Vorteil, dass dieser nur schwer durch den Spalt hindurch in den I<ühlkanal gelangen kann.

In Varianten kann das Profil und die Klebenut auch derart ausgebildet sein, dass die Spaltbreite hin zum distalen Ende des Profils zunimmt oder abnimmt. Bei abnehmender Spaltbreite kann erwartet werden, dass bei einem zusammenfügen des Deckkörpers mit dem Grundkörper der Klebstoff ebenfalls nicht über die Rippe in den I<ühlkanal eintreten kann. Anderseits würde damit möglicherweise ein Totvolumen geschaffen, welches die Funktion des I<ühlkanals negativ beeinflussen könnte.

Bevorzugt beschreibt der Profilschnitt auf einer dem I<ühlkanal abgewandten Seite, in einem distalen Bereich hin zu einem distalen Ende des Profils eine Kurve, wobei insbesondere eine Kurvensteigung der Kurve sich streng monoton ändert. Damit weist der Profilabschnitt hin zum distalen Ende eine Form der Art eines Flügels auf. Damit wird mutmasslich beim Fügen des Profils in die Klebenut ein Unterdruck erzeugt, welcher ein Eintreten des Klebstoffs in den I<ühlkanal verhindert. In Varianten kann auf die Kurvenform auch verzichtet werden, insbesondere kann der distale Bereich hin zu einem distalen Ende des Profils im Querschnitt auch polygonal geformt sein.

Besonders bevorzugt verläuft zusätzlich der Profilschnitt auf einer dem I<ühlkanal zugewandten Seite, in einem distalen Bereich rechtwinklig zur Längsrichtung der Klebenut gerade. In varianten der Profilschnitt auf einer dem I<ühlkanal abgewandten Seite auch eine andere Form aufweisen.

Vorzugsweise weist in montiertem Zustand des Kühlkörpers die Kurve am distalen Ende des Profils einen spitzen Winkel, vorzugsweise einen Winkel kleiner 20°, insbesondere bevorzugt einen Winkel kleiner 5°, weiter bevorzugt einen Winkel kleiner 1° zur Grundkörperebene auf. In Varianten kann der Winkel zur Grundkörperebene auch stumpf sein. Durch den spitzen Winkel wird erreicht, dass das 1<lebevolumen während dem Einfahren des Profils in die Klebenut bestmöglich von dem I<ühlkanal weg geführt wird. Dazu weist die Klebenut vorzugsweise einen rechteckigen Querschnitt auf, so dass in montiertem Zustand des I<ühlkörpers die Kurve am distalen Ende des Profils einen spitzen Winkel zum I<ühlkanalboden aufweist. In Varianten kann der I<ühlkanalboden aber auch anders geformt sein.

Bevorzugt beschreibt der Profilschnitt auf einer dem I<ühlkanal abgewandten Seite, in einem distalen Bereich hin zu einem distalen Ende des Profils eine Kurve mit einem im Wesentlichen konstanten Kurvenradius, wobei insbesondere der Kurvenradius im Wesentlichen einer Breite des Profils entspricht. In den Versuchen hat sich diese Form als besonders vorteilhaft erwiesen, um zu verhindern, dass während der Montage Klebstoff in den I<ühlkanal gelangt. Die distale Profilkante des Profils kann damit einen im Wesentlichen halbkreisförmigen Abschluss aufweisen. Dem Fachmann ist klar, dass die distale Profilkante des Profils auch von einem geometrisch exakten halbkreisförmigen Abschluss mit einem Radius R abweichen kann, insbesondere zum Beispiel in einem Bereich von 0.75*R bis 1.25*R, vorzugsweise 0.9*R bis 1.1*R. In Varianten kann der Kurvenradius auch kleiner oder grösser als die Breite des Profils sein.

Bevorzugt ist ein Querschnitt der Klebenut im Wesentlichen rechteckig. Diese Form hat sich einerseits herstellungsbedingt und anderseits auch für die Montage als besonders vorteilhaft erwiesen. Dem Fachmann ist klar, dass die Rechteckform den Bodenbereich der Klebenut beschreibt, insbesondere da die Klebenut vor der Montage gegen oben offen ist. In Varianten kann die Klebenut im Bodenbereich auch anderweitig geformt sein, insbesondere kann die Nut einen geneigten, einen gekrümmten oder anderweitig geformten Boden aufweisen.

Vorzugsweise beträgt ein Verhältnis zwischen einer Rippenhöhe zu einer 1<lebenutbreite zwischen 3:1 und 1:3, vorzugsweise zwischen 2:1 und 1:2, insbesondere bevorzugt zwischen 1.5:1 und 1:1.5. Das Verhältnis kann aber auch ausserhalb des Bereichs von 3:1 und 1:3 liegen.

Bevorzugt ist bei mit dem Deckkörper abgedecktem Grundkörper eine maximale Spaltbreite zwischen der Rippe und dem Profil kleiner als 1/10 der Breite des Profils, vorzugsweise kleiner als 1/20 der Breite des Profils, insbesondere bevorzugt kleiner als 1/25 der Breite des Profils. Damit wird die Spaltbreite hinreichend klein gewählt, dass dem Klebstoff bei der Montage ein hinreichend grosser Widerstand entgegen gesetzt wird, so dass der Klebstoff nicht durch den Spalt hindurch in den I<ühlkanal gelangt. In Varianten kann die Spaltbreite auch grösser als 1/10 der Breite des Profils sein, insbesondere wenn das Profil eine sehr geringe Breite aufweist.

Bevorzugt ist bei mit dem Deckkörper abgedecktem Grundkörper eine minimale Spaltbreite zwischen der Rippe und dem Profil grösser als 1/100 der Breite des Profils, vorzugsweise grösser als 1/50 der Breite des Profils. Damit wird sichergestellt, dass der Klebstoff während der Montage zumindest teilweise dem Spalt entlang nach oben dringen kann, um so eine optimale und dichte Verbindung zwischen dem Deckkörper und dem Grundkörper zu schaffen. In Varianten kann die Spaltbreite auch weniger als 1/100 der Breite des Profils betragen.

Vorzugsweise beträgt die Spaltbreite zwischen der Rippe und dem Profil zwischen 5 mm und 0.01mm, vorzugsweise zwischen 1 mm und 0.1 mm. In Varianten, je nach Dimensionierung des I<ühlkanals und je nach Viskosität des Klebstoffes kann die Spaltbreite auch grösser als 5 mm oder kleiner als 0.01 mm sein.

Bevorzugt ist bei mit dem Deckkörper abgedecktem Grundkörper eine minimale Spaltbreite zwischen dem Profil einer der Rippe gegenüberliegenden Seite der Klebenut kleiner als 1/10 der Breite des Profils, vorzugsweise kleiner als 1/20 der Breite des Profils, insbesondere bevorzugt kleiner als 1/25 der Breite des Profils. In Varianten kann die Spaltbreite auch grösser als 1/10 der Breite des Profils sein, insbesondere wenn das Profil eine sehr geringe Breite aufweist.

Bevorzugt ist bei mit dem Deckkörper abgedecktem Grundkörper eine minimale Spaltbreite zwischen dem Profil einer der Rippe gegenüberliegenden Seite der Klebenut grösser als 1/100 der Breite des Profils, vorzugsweise grösser als 1/50 der Breite des Profils. In Varianten kann die Spaltbreite auch weniger als 1/100 der Breite des Profils betragen.

Bevorzugt ist bei mit dem Deckkörper abgedecktem Grundkörper eine minimale Spaltbreite zwischen dem Profil einer der Rippe gegenüberliegenden Seite der Klebenut zwischen 1 mm und 0.001mm, vorzugsweise zwischen 0.1 mm und 0.01 mm. In Varianten, je nach Dimensionierung des I<ühlkanals und je nach Viskosität des Klebstoffes kann die Spaltbreite auch grösser als 1 mm oder kleiner als 0.001 mm sein.

Vorzugsweise weist eine Stirnseite der Rippe hin zur Klebenut einen Absatz auf, welcher bei mit dem Deckkörper abgedecktem Grundkörper vorzugsweise den Deckkörper kontaktiert und welcher insbesondere stirnseitig einen Spalt zwischen dem Deckkörper und der Rippe hin zum I<ühlkanal begrenzt, wobei bevorzugt eine Spalthöhe zwischen dem Deckkörper und der Rippe kleiner als 1/10 der Breite des Profils, vorzugsweise kleiner als 1/20 der Breite des Profils, insbesondere bevorzugt kleiner als 1/25 der Breite des Profils ist. Damit wird eine Begrenzung für den Klebstoff geschaffen. Insbesondere wenn zum Beispiel die Klebstoffmenge bei der Montage zu gross gewählt wird, kann mit dem Absatz ein Eindringen von Klebstoff in den I<ühlkanal verhindert werden. Gegebenenfall kann auf diesen Absatz auch verzichtet werden, insbesondere wenn die Dosierung und Verteilung des Klebstoffs in der Klebenut hinreichend präzise erfolgen kann.

Vorzugsweise liegt der Deckkörper in montiertem Zustand auf der Rippe des Grundkörpers auf. Damit wird einerseits eine besonders präzise Verbindung zwischen Grundkörper und Deckkörper erreicht. Anderseits wird damit weiter wirksam ein Eindringen von Klebstoff in den I<ühlkanal während der Montage verhindert. In Varianten kann auf die Auflage des Deckkörpers auf der Rippe auch verzichtet werden.

Vorzugsweise ist der Deckkörper plattenförmig ausgebildet, wobei das Profil an einem Randbereich des Deckkörpers ausgebildet ist und wobei insbesondere bei mit dem Deckkörper abgedecktem Grundkörper eine dem I<ühlkanal gegenüberliegende Oberfläche des Deckkörpers, zumindest in einem Teilbereich eines Übergangsbereichs zwischen der Oberfläche des Deckkörpers und einer Oberfläche des Grundkörpers, mit der Oberfläche des Grundkörpers fluchtet. Damit kann der Deckkörper in einer Bevorzugten Ausführungsform dem I<ühlkanal entsprechend dimensioniert sein, so dass der Deckkörper, zumindest einseitig des I<ühlkanals durch den 1<lebekanal begrenzt ist. Damit wird erreicht, dass der Deckkörper in montierten Zustand ausschliesslich auf der Rippe aufliegt, womit eine besonders präzise Verbindung zwischen dem Grundkörper und dem Deckkörper erreicht wird.

In Varianten kann das Profil auch innerhalb des plattenförmigen Bereichs des Deckkörper ausgebildet sein, so dass der plattenförmige Bereich über das Profil hinausragen kann. Damit kann eine weitere Auflage für den Deckkörper auf dem Grundkörper erreicht werden.

Vorzugsweise ist die Klebenut auf einer der Rippe gegenüberliegenden Seite durch eine Wand begrenzt, welche die Rippe um eine Dicke des Deckkörpers überragt. Damit wird erreicht, dass in montiertem Zustand der Deckkörper mit einer Oberfläche des Grundkörpers fluchtet. Damit wird eine ebene Oberfläche erreicht. Dem Fachmann ist jedoch klar, dass je nach Anwendung auch eine nicht ebene Oberfläche des I<ühlelements gewünscht sein kann, womit auf dieses Merkmal auch verzichtet werden kann.

Im Verfahren zur Herstellung eines I<ühlkörpers wird ein Klebstoff in die Klebenut eingetragen und anschliessend wird der Deckköper derart auf dem Grundkörper angeordnet wird, dass das Profil in die Nut hinein ragt und der Klebstoff das Profil in der Nut festklebt.

Im fertig gestellten I<ühlkörper ist der Deckkörper derart auf dem Grundkörper angeordnet, dass das Profil in die Nut hinein ragt und wobei das Profil mit einem Klebstoff in der Nut verklebt ist. Vorzugsweise ist der Klebstoff ein Epoxidklebstoff, insbesondere Araldit^{®} oder ein Polyurethan. Dem Fachmann sind auch andere geeignete Klebstoffe bekannt.

Vorzugsweise ist der Deckkörper derart auf dem Grundkörper verklebt, dass der I<ühlkanal bis zu einem Unterdruck von 10⁻⁶ mbar, vorzugsweise bis zu einem Unterdruck von 10⁻⁸ mbar, insbesondere bevorzugt bis zu einem Unterdruck von 10⁻⁹ mbar dicht ist. In Varianten kann auf diese Anforderung auch verzichtet werden.

Vorzugsweise wird der Grundkörper für den Klebevorgang fixiert, insbesondere vorgespannt. Damit wird ein besonders präzise Verbindung zwischen dem Deckkörper und dem Grundkörper erreicht, insbesondere kann damit verhindert werden, dass sich der Grundkörper und/oder der Deckkörper während des Fügvorgangs verzieht. In Varianten kann auf das Vorspannen verzichtet werden.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: eine schematische Schnittdarstellung rechtwinklig zu einer Grundkörperebene in Richtung des I<ühlkanals bei einem I<ühlkörper nach dem Stand der Technik;
- Fig. 2a: eine schematische Schnittdarstellung rechtwinklig zu einer Grundkörperebene in Richtung des I<ühlkanals einer Ausführungsform des erfindungsgemässen Grundkörpers;
- Fig. 2b: eine schematische Schnittdarstellung rechtwinklig zu einer Längsrichtung eines Deckkörpers zum Abdecken des I<ühlkanals gemäss Figur 2a;
- Fig. 2c: eine schematische Schnittdarstellung rechtwinklig zu einer Grundkörperebene in Richtung des I<ühlkanals respektive der Klebenut bei einer Ausführungsform des erfindungsgemässen I<ühlkörpers;
- Fig. 3a: eine schematische Schnittdarstellung gemäss Figur 3, vor dem Fügvorgang;
- Fig. 3b: eine schematische Schnittdarstellung gemäss Figur 3, während dem Fügvorgang;
- Fig. 3c: eine schematische Schnittdarstellung gemäss Figur 3, nach Abschluss des Fügvorgangs;

Grundsätzlich sind in den Figuren gleiche Teile mit gleichen Bezugszeichen versehen.

### Wege zur Ausführung der Erfindung

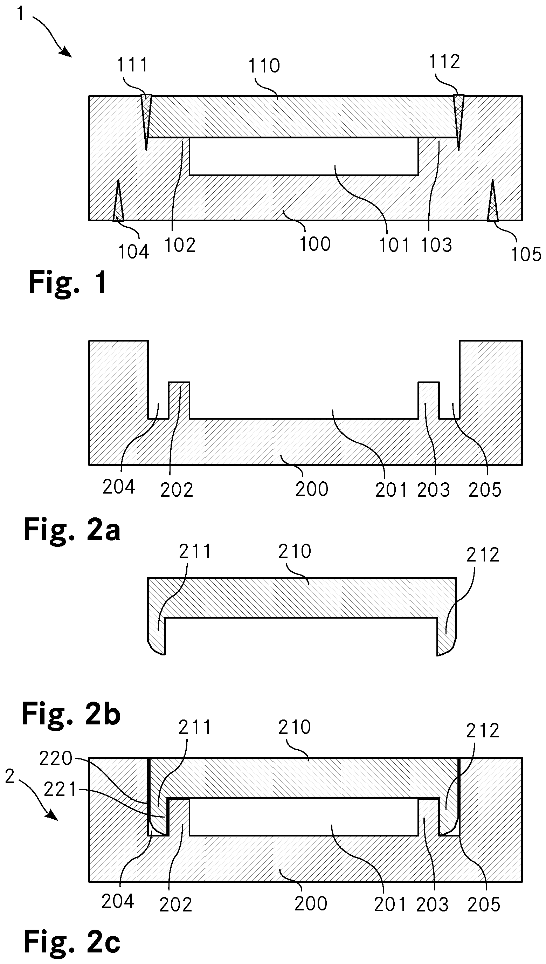

Die Figur. 1 zeigt eine schematische Schnittdarstellung rechtwinklig zu einer Grundkörperebene in Richtung des I<ühlkanals 101 bei einem I<ühlkörper 1 nach dem Stand der Technik. Der Grundkörper 100 ist vorliegend plattenförmig ausgebildet und weist einen I<ühlkanal 101 auf, in welchem ein I<ühlmedium geführt werden kann. Der I<ühlkanal 101 verläuft in einer Längsrichtung und ist beidseitig durch einen Absatz 102, 103 flankiert. Die Absätze 102, 103 dienen als Auflage für den Deckkörper 110, mit welchem der I<ühlkanal 101 abgedeckt wird.

Der Grundkörper 100 und der Deckkörper 110 sind vorliegend aus Aluminium hergestellt. Der I<ühlkanal 101 und die beiden Absätze 102, 103 sind mittels Fräsvorgang in den Grundkörper 100 eingebracht.

Im Herstellungsprozess wird der Deckkörper 110 auf den Absätzen 102, 103 positioniert und anschliessend wird der Deckkörper 110 mit dem Grundkörper 100 verschweisst. Die Schweissnähte sind in der Figur 1 mit 111 und 112 gekennzeichnet.

Aufgrund des Schweissvorgangs ergeben sich Spannungen im I<ühlkörper 1, womit sich dieser verziehen kann. bei manchen Kühlkörpern 1 kann diesem Effekt durch Gegenschweissen auf der, dem I<ühlkanal 101 gegenüberliegenden Seite des Grundkörpers 100 durch die Schweissnähte 104, 105 zumindest teilweise entgegen gewirkt werden.

Die so hergestellten I<ühlkörper 1 müssen im Anschluss nachbearbeitet werden, um den Verzug zu kompensieren oder abzutragen.

Das nachfolgend beschriebene I<ühlelement weist eine Grösse von 300mm x 500mm auf. In der Praxis kann die Grösse stark variieren, insbesondere von einigen mm bis hin zu Europalettengrösse (1200mm x800mm). Die Dicke liegt vorliegend zwischen 20 mm und 40mm. Auch die Dicke kann in einem weiteren Bereich variieren, insbesondere zwischen 5mm und 100mm, vorzugsweise zwischen 10mm und 50mm).

Die Figur 2a zeigt eine schematische Schnittdarstellung rechtwinklig zu einer Grundkörperebene in Richtung des I<ühlkanals einer Ausführungsform des erfindungsgemässen Grundkörpers 200. Der Grundkörper 200 ist vorliegend plattenförmig ausgebildet und weist einen I<ühlkanal 201 auf, in welchem ein I<ühlmedium geführt werden kann. Der I<ühlkanal 201 weist eine Breite von 10 - 30 mm auf. Beidseitig des I<ühlkanals ist eine Klebenut 204, 205 angeordnet, welche jeweils durch eine Rippe 202, 203 vom I<ühlkanal getrennt ist. Die Klebenut 204, 205 weist jeweils eine Breite in einem Bereich von 2 mm bis 5 mm auf. Die Rippe weist eine Breite zwischen 1 und 3 mm und eine Höhe in einem Bereich von 2 mm bis 5 mm auf. Der I<ühlkanal 201 als auch die 1<lebenuten 204, 205 weisen vorliegend einen rechteckigen Querschnitt auf. Die 1<lebenuten 204, 205 sind jeweils auf einer der Rippe 202, 203 gegenüberliegenden Seite durch eine Wand begrenzt, welche um eine Dicke des Deckkörpers 210 die Rippen 202, 203 überragt (siehe Figur 2c). Die Dicke des Deckkörpers 210 beträgt vorliegend zwischen 2 mm und 20 mm.

Der Grundkörper 200 ist vorliegend aus Aluminium hergestellt. Der I<ühlkanal 201 und die beiden 1<lebenuten 204, 205 als auch die Rippen 202, 203 sind durch Frästen in den Grundkörper 100 eingebracht.

Die Figur 2b zeigt eine schematische Schnittdarstellung rechtwinklig zu einer Längsrichtung eines Deckkörpers 210 zum Abdecken des I<ühlkanals 201 gemäss Figur 2a. Der Deckkörper 210 weist in den seitlichen Randbereichen jeweils rechtwinklig zu einer Hauptebene des Deckkörpers 210 zwei parallel verlaufende Profile 211 und 212 auf. Diese sind dazu ausgebildet, um im montierten Zustand in die 1<lebenuten zu ragen um in verklebtem Zustand den Deckkörper 210 auf dem Grundkörper 200 der Figur 2a zu fixieren.

Die Profile 211, 212 sind an den zueinander abgewandten Seiten zum distalen Ende hin halbkreisförmig abgerundet. An den einander zugewandten Seiten sind die Profile 211, 212 eben und parallel ausgebildet. Die abgerundete Form dient bei der Montage des Deckkörpers 210 auf dem Grundkörper dazu, den Klebstoff in der Klebenut 204, 205 tendenziell von dem I<ühlkanal weg zu führen, so dass kein Klebstoff in den I<ühlkanal gelangt.

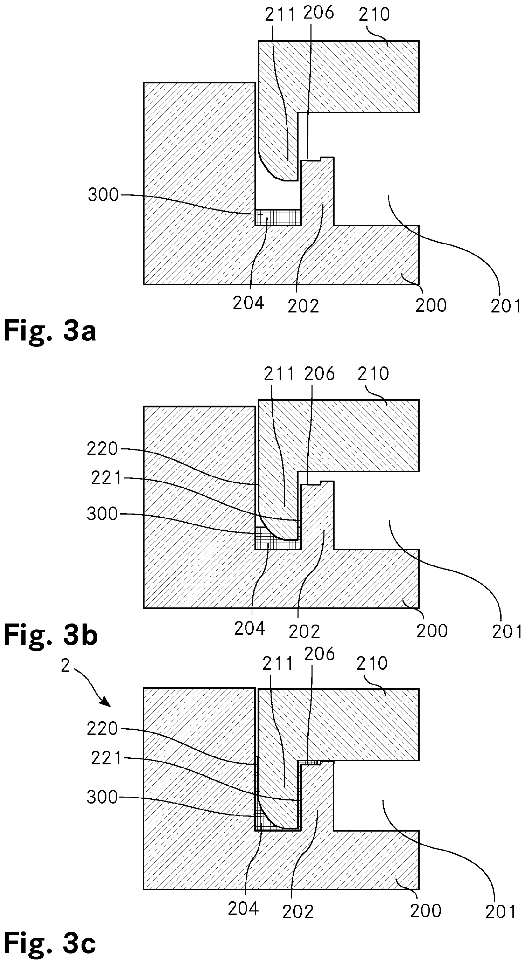

Es wird vermutet, dass beim Eintauchen des Profils in die, den Klebstoff enthaltende Klebenut nach dem Wirkprinzip von Tragflächen ein Unterdruck derart erzeugt werden kann, dass ein Eindringen von Klebstoff in den I<ühlkanal verhinderbar ist (siehe weiter unten, zu den Figuren 3a bis 3c).

Obschon vorliegend die Profile 211, 212 randseitig am Deckkörper 210 ausgebildet sind, können in anderen Varianten die Profile 211, 212 auch am Deckkörper 210 nach innen versetzt ausgebildet sein, so dass ein plattenförmiger Bereich des Deckkörpers 210 über die Profile 211, 212 übersteht.

Die Figur 2c zeigt eine schematische Schnittdarstellung rechtwinklig zu einer Grundkörperebene in Richtung des I<ühlkanals respektive der Klebenut bei einer Ausführungsform eines erfindungsgemässen I<ühlkörpers 2 in zusammengesetztem Zustand. Dabei ist ersichtlich, dass die Profile 211, 212 jeweils in die 1<lebenutzen hineinragen. Zwischen dem Profil 211, 212 und der Klebenut 204, 205 ist beidseitig ein Spalt 220, 221 vorgesehen, in welchem bei der Montage der Klebstoff die Verbindung zwischen Grundkörper 200 und Deckkörper 210 herstellt. Die Spaltbreite beträgt vorliegend 0.05mm.

In den nachfolgenden Figuren 3a bis 3c ist das Verfahren zur Herstellung des I<ühlkörpers 2 aus dem Grundkörper 200 und den Deckkörper 210 unter Verwendung eines Klebstoffes als Detailansicht dargestellt.

Die Figur 3a zeigt eine schematische Schnittdarstellung einer Vergrösserung der linken Seite des I<ühlkörpers 2 gemäss der Figur 2c, vor dem Fügvorgang. In der vergrösserten Darstellung ist ersichtlich, dass die Rippe 202 stirnseitig einen Absatz 206 aufweist, welcher hin zum I<ühlkanal 201 begrenzt ist. Damit wird ein Eindringen von Klebstoff in den I<ühlkanal 201 verhindert. Alternativ kann auf den Absatz verzichtet werden, insbesondere, wenn die Klebstoffmenge entsprechend gering gewählt wird.

Im ersten Schritt wird ein Klebstoff 300, vorliegend Araldit^{®} in die Klebenut eingefüllt. Die Menge wird dabei derart gewählt, dass in zusammengefügtem Zustand der Klebstoff 300 nicht in den I<ühlkanal 201 gelangt. Es ist zu beachten, dass das Eindringen des Klebstoffes 300 in den I<ühlkanal nicht ausschliesslich durch die Klebstoffmenge gesteuert wird, sondern mutmasslich auch durch die Form des Profils 211. Die Klebstoffmenge darf aufgrund der Anforderungen an die Dichtheit des I<ühlkörpers 2 auch nicht beliebig klein gewählt werden. Der zwischen notwendig und hinreichend liegende Bereich der Klebstoffmenge kann aufgrund der Abmessungen der Klebenut 204 und des Profils 211 durch den Fachmann berechnet werden.

Die Figur 3b zeigt eine schematische Schnittdarstellung gemäss Figur 3a, während dem Fügvorgang. Im zweiten Schritt wird nun der Deckkörper 210 auf den Grundkörper 200 gefügt, womit das Profil 211 in die Klebenut 204 und damit in den Klebstoff 300 eindringt. Damit wird der Klebstoff 300 seitlich verdrängt. Aufgrund der abgerundeten Form des Profils 211 wird während dem Fügvorgang der Klebstoff mehrheitlich von dem I<ühlkanal weg gedrängt, womit kein Klebstoff 300 in den I<ühlkanal gelangt. Während des Fügvorgangs wird der Klebstoff 300 entlang des Spalts 220 und 221 hoch geführt und führt damit zu einer optimalen Verklebung des Deckkörpers 210 mit dem Grundkörper 200. Der Absatz 206 dient als Sicherheit, um ein Eindringen von Klebstoff in den I<ühlkanal 201 zu verhindern.

Die Figur 3c zeigt schliesslich eine schematische Schnittdarstellung gemäss Figur 3b, nach Abschluss des Fügvorgangs. In diesem Zustand ist insbesondere ersichtlich, dass der Deckköprer 210 auf der Rippe 202 aufliegt, womit eine Trennung des I<ühlkanals 201 von der Klebenut 204 und damit von dem Klebstoff 300 erfolgt.

Zusammenfassend ist festzustellen, dass erfindungsgemäss eine Anordnung zur Herstellung eines I<ühlkörpers sowie ein I<ühlkörper geschaffen wird, welcher besonders effizient hergestellt werden kann und bei welchem ein Aufwand einer Nachbearbeitung reduziert ist.

## Patentansprüche

1. Anordnung zur Bildung eines I<ühlkörpers (2), umfassend einen Grundkörper (200) und einen Deckkörper (200), wobei im Grundkörper (200) ein I<ühlkanal (204, 205) in einer Grundkörperebene angeordnet ist, wobei der I<ühlkanal (204, 205) zumindest einen offenen I<ühlkanalabschnitt umfasst, wobei mit dem Deckkörper (210) der Grundkörper (200) zur Bildung des I<ühlkörpers (2)derart abgedeckt werden kann, dass der offene I<ühlkanalabschnitt mit dem Deckkörper (200) abdeckbar ist, **dadurch gekennzeichnet, dass** der Grundkörper (200) weiter eine Klebenut (204, 205) zur Aufnahme eines Klebstoffes (300) aufweist und der Deckkörper (200) ein Profil (211, 212) aufweist, wobei das Profil (211, 212) bei mit dem Deckkörper (200) abgedecktem Grundkörper (200) in die Klebenut (204, 205) hinein ragt.

2. Anordnung nach Anspruch 1, **dadurch gekennzeichnet, dass** zwischen der Klebenut (204, 205) und dem I<ühlkanal (204, 205) eine Rippe ausgebildet ist, welche die Klebenut (204, 205) von dem I<ühlkanal (204, 205) trennt.

3. Anordnung nach Anspruch 1 oder 2, **dadurch gekennzeichnet, dass** das Profil (211, 212) und die Klebenut (204, 205) derart ausgebildet sind, dass bei einem Einfügen des Profils (211, 212) in die Klebenut (204, 205) auf einer dem I<ühlkanal (204, 205) gegenüberliegenden Seite des Profils (211, 212) ein Unterdruck erzeugbar ist, womit bei einem Klebevorgang ein Eindringen von Klebstoff (300) in den I<ühlkanal (204, 205) verhinderbar ist.

4. Anordnung nach einem der Ansprüche 1 bis 3, **dadurch gekennzeichnet, dass** bei mit dem Deckkörper (200) abgedecktem Grundkörper (200) das Profil (211, 212) einen Profilschnitt rechtwinklig zu einer Längsrichtung der Klebenut (204, 205) aufweist, wobei der Profilschnitt asymmetrisch ist und insbesondere eine Breite sich in einem Distalen Bereich des Profilschnitts hin zu einem distalen Ende des Profilschnitts kontinuierlich verjüngt.

5. Anordnung nach Anspruch 4, **dadurch gekennzeichnet, dass** der Profilschnitt auf einer dem I<ühlkanal (204, 205) zugewandten Seite, in einem distalen Bereich rechtwinklig zur Längsrichtung der Klebenut (204, 205) gerade verläuft.

6. Anordnung nach Anspruch 4 oder 5, **dadurch gekennzeichnet, dass** der Profilschnitt auf einer dem I<ühlkanal (204, 205) abgewandten Seite, in einem distalen Bereich hin zu einem distalen Ende des Profils (211, 212) eine Kurve beschreibt, wobei insbesondere eine Kurvensteigung der Kurve sich streng monoton ändert.

7. Anordnung nach einem der Ansprüche 4 bis 6, **dadurch gekennzeichnet, dass** der Profilschnitt auf einer dem I<ühlkanal (204, 205) abgewandten Seite, in einem distalen Bereich hin zu einem distalen Ende des Profils (211, 212) eine Kurve mit einem im Wesentlichen konstanten Kurvenradius beschreibt, wobei insbesondere der Kurvenradius im Wesentlichen einer Breite des Profils (211, 212) entspricht.

8. Anordnung nach einem der Ansprüche 1 bis 7, **dadurch gekennzeichnet, dass** ein Querschnitt der Klebenut (204, 205) im Wesentlichen rechteckig ist und insbesondere ein Verhältnis zwischen einer Rippenhöhe zu einer 1<lebenutbreite zwischen 3:1 und 1:3, vorzugsweise zwischen 2:1 und 1:2, insbesondere bevorzugt zwischen 1.5:1 und 1:1.5 beträgt.

9. Anordnung nach einem der Ansprüche 1 bis 8, **dadurch gekennzeichnet, dass** bei mit dem Deckkörper (200) abgedecktem Grundkörper (200) eine maximale Spaltbreite zwischen der Rippe und dem Profil (211, 212) kleiner ist als 1/10 der Breite des Profils (211, 212), vorzugsweise kleiner als 1/20 der Breite des Profils (211, 212), insbesondere bevorzugt kleiner als 1/25 der Breite des Profils (211, 212).

10. Anordnung nach einem der Ansprüche 1 bis 9, **dadurch gekennzeichnet, dass** eine Stirnseite der Rippe hin zur Klebenut (204, 205) einen Absatz aufweist, welcher bei mit dem Deckkörper (200) abgedecktem Grundkörper (200) vorzugsweise den Deckkörper (200) kontaktiert und welcher insbesondere stirnseitig einen Spalt zwischen dem Deckkörper (200) und der Rippe hin zum I<ühlkanal (204, 205) begrenzt, wobei bevorzugt eine Spalthöhe zwischen dem Deckkörper (200) und der Rippe kleiner ist als 1/10 der Breite des Profils (211, 212), vorzugsweise kleiner als 1/20 der Breite des Profils (211, 212), insbesondere bevorzugt kleiner als 1/25 der Breite des Profils (211, 212) ist.

11. Anordnung nach einem der Ansprüche 1 bis 10, **dadurch gekennzeichnet, dass** der Deckkörper (200) plattenförmig ausgebildet ist, wobei das Profil (211, 212) an einem Randbereich des Deckkörpers (200) ausgebildet ist und wobei insbesondere bei mit dem Deckkörper (200) abgedecktem Grundkörper (200) eine dem I<ühlkanal (204, 205) gegenüberliegende Oberfläche des Deckkörpers (200), zumindest in einem Teilbereich eines Übergangsbereichs zwischen der Oberfläche des Deckkörpers (200) und einer Oberfläche des Grundkörpers (200), mit der Oberfläche des Grundkörpers (200) fluchtet.

12. I<ühlkörper (2) hergestellt mit einer Anordnung nach einem der Ansprüche 1 bis 11, **dadurch gekennzeichnet, dass** der Deckkörper (200) derart auf dem Grundkörper (200) angeordnet ist, dass das Profil (211, 212) in die Nut hinein ragt und wobei das Profil (211, 212) mit einem Klebstoff (300) in der Nut verklebt ist.

13. I<ühlkörper (2) nach Anspruch 12, **dadurch gekennzeichnet, dass** der Klebstoff (300) ein Epoxidklebstoff, insbesondere Araldit^{®} oder ein Polyurethan ist.

14. Verfahren zur Herstellung eines I<ühlkörpers (2) mit einer Anordnung nach einem der Ansprüche 1 bis 11, **dadurch gekennzeichnet, dass** ein Klebstoff (300) in die Klebenut (204, 205) eingetragen wird und anschliessend der Deckköper derart auf dem Grundkörper (200) angeordnet wird, dass das Profil (211,212) in die Nut hinein ragt und der Klebstoff (300) das Profil (211, 212) in der Nut festklebt.

15. Verfahren nach Anspruch 14, **dadurch gekennzeichnet, dass** das Profil (211, 212) und die Klebenut (204, 205) derart ausgebildet sind, dass beim Einfügen des Profils (211, 212) in die, den Klebstoff (300) enthaltende Klebenut (204, 205) der Klebstoff (300) im Wesentlichen auf eine dem I<ühlkanal (204, 205) gegenüberliegenden Seite des Profils (211, 212) verdrängt wird.

16. Verfahren nach Anspruch 14 oder 15, **dadurch gekennzeichnet, dass** der Grundkörper (200) für den Klebevorgang fixiert, insbesondere vorgespannt wird.
